# EUROPEAN PATENT APPLICATION

(11) **EP 4 651 209 A1**
(43) Date of publication of application: **19.11.2025**
(21) Application number: 24810379.8
(22) Date of filing: 21.05.2024
(51) Int. Cl.: H01L 31/02

(54) **BUSBAR-FREE BACK CONTACT CELL, CELL MODULE AND PHOTOVOLTAIC SYSTEM**

(30) Priority: 22.05.2023 CN 202310580617; 22.05.2023 CN 202321248035 U
(71) Applicant: Zhuhai Fushan Aiko Solar Energy Technology Co., Ltd., FushanIndustrial Park, Doumen District Zhuhai Guangdong 519000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Zhejiang Aiko Solar Energy Technology Co., Ltd., Yiwu, Jinhua Zhejiang 322000 (CN)
(72) Inventor: TAN, Lixiang, Zhuhai, Guangdong 519000 (CN); WANG, Yongqian, Zhuhai, Guangdong 519000 (CN); ZHANG, Ning, Zhuhai, Guangdong 519000 (CN); SONG, Yi, Zhuhai, Guangdong 519000 (CN); CHEN, Gang, Zhuhai, Guangdong 519000 (CN)
(74) Representative: EP&C
(86) International application number: PCT/CN2024/094376
(87) International publication number: WO 2024/240137

(57) **Abstract**

The present disclosure is applicable to the technical field of solar cells, and provides a busbar-free back contact cell (100), a cell module and a photovoltaic system. The busbar-free back contact cell (100) includes a cell substrate (10), first insulating members (21) and conductive members, wherein alternately distributed fingers of two polarities are formed on the back surface of the cell substrate (10), the back surface includes alternately distributed current-confluence regions (13) and non-current-confluence regions (14), and parts of each finger are located in the current-confluence regions (13), and the rest parts of each finger is located in the non-current-confluence regions (14); the current-confluence regions (13) include electrically connected regions (101), and the first insulating members (21) are arranged in the current-confluence regions (13) and cover fingers having a polarity opposite to that of the current-confluence regions (13) to expose the electrically connected regions (101); and the conductive members are arranged in the electrically connected regions (101).

## Description

The present disclosure claims the priority based on Chinese patent application filed with the China National Intellectual Property Administration on May 22, 2023, with application number 2023105806174, and titled "Busbar-free Back Contact Cell, Cell Module and Photovoltaic System", which is incorporated herein by reference in its entirety.

### Technical Field

The present disclosure relates to the technical field of solar cells, and in particular, to a busbar-free back contact cell, a cell module and a photovoltaic system.

### Background

Solar cell power generation is a sustainable source of clean energy that utilizes the photovoltaic effect of semiconductor p-n junctions to convert sunlight into electrical energy.

In the busbar-free back contact cells in the related art, the fingers of two polarities are alternately distributed. When collecting current from the sub-fingers via interconnectors, the fingers can easily conduct with interconnectors of opposite polarity, thereby leading to a short circuit.

### Summary

### Technical Problem

How to reduce the risk of short circuits in busbar-free back contact cells has become an urgent problem that needs to be solved.

### Technical Solution

The present disclosure provides a busbar-free back contact cell, a cell module and a photovoltaic system, which are intended to solve the problem of reducing the risk of short circuits in busbar-free back contact cells.

The busbar-free back contact cell provided in the present disclosure includes a cell substrate, first insulating members and conductive members, wherein alternately distributed fingers of two polarities are formed on a back surface of the cell substrate, the back surface includes alternately distributed current-confluence regions and non-current-confluence regions, and parts of each finger are located in the current-confluence regions, and the rest parts of each finger are located in the non-current-confluence regions; the current-confluence regions include electrically connected regions, and the first insulating members are arranged in the current-confluence regions and cover fingers having a polarity opposite to a polarity of the current-confluence regions to expose the electrically connected regions; and the electrical conductive members are arranged in the electrically connected regions.

Optionally, a thickness of the first insulating members is 10 µm-50 µm.

Optionally, a length of the first insulating members is 1 mm-3 mm.

Optionally, a width of the first insulating members is 0.2 mm-0.6 mm.

Optionally, a height of the conductive members is 30 µm-100 µm.

Optionally, an area of the electrically connected regions is 0.02 mm²-0.6 mm².

Optionally, a number of the electrically connected regions is 1000-4000.

Optionally, the busbar-free back contact cell includes second insulating members, and each second insulating member connects two adjacent first insulating members and, together with the adjacent first insulating members, encloses the electrically connected region.

Optionally, a width of the second insulating members is 1 mm-3 mm.

Optionally, the first insulating members are transparent insulating members.

Optionally, the first insulating members are transparent fluorescent insulating members.

Optionally, the transparent fluorescent insulating members are composed of a transparent insulating adhesive, and the transparent insulating adhesive includes:
a resin component in an amount of 60 to 80 wt%;
an inorganic filler in an amount of 5 to 15 wt%;
a curing agent in an amount of 5 to 15 wt%;
a solvent in an amount of less than 10 wt%; and
a phosphor in an amount of greater than or equal to 0.1 wt% and less than 1 wt%.

Optionally, the phosphor includes at least one of fluorescent brightener OB-1, fluorescent brightener OB, aluminum oxide, zinc oxide, zinc sulfide, calcium sulfide, strontium sulfide, strontium aluminate, calcium chlorate, barium aluminate, rare-earth phosphors, fluorescent brightener BC, fluorescent brightener JD-3, fluorescent brightener BR, fluorescent brightener EBF, fluorescent brightener R, fluorescent brightener ER, 1,8-naphthalimide-based fluorescent compounds, polyphenylene, polythiophene, polyfluorene, polytriphenylamine, triphenylamine-based polymer derivatives, polycarbazole, polypyrrole, porphyrin-based polymers and derivatives thereof, copolymers, N,N-dimethylaminobenzylidene malononitrile compounds, 8-hydroxyquinoline aluminum, and europium metal complexs.

The cell module provided in the present disclosure includes the busbar-free back contact cell of any one of the described items.

The photovoltaic system provided in the present disclosure includes the described cell module.

### Advantageous Effects

For the busbar-free back contact cell, the cell module and the photovoltaic system in the embodiments of the present disclosure, as the first insulating members are arranged in the current-confluence regions and cover fingers having a polarity opposite to a polarity of the current-confluence regions, the conduction between the fingers of opposite polarity and ribbons can be avoided in the current-confluence regions, thereby reducing the risk of short circuits in the busbar-free back contact cell. In addition, as the conductive members are arranged in the electrically connected region, they facilitate the connection between the fingers of the same polarity and the interconnectors, so that the interconnectors connect the busbar-free back contact cells in series into a cell string, and output current from the busbar-free back contact cells. Furthermore, as there is no busbar, the use of busbar paste can be omitted, reducing the cost.

### Brief Description of the Drawings

Fig. 1 is a schematic diagram showing the structure of a partial region of a busbar-free back contact cell according to an embodiment of the present disclosure;
Fig. 2 is a schematic diagram showing the structure of a cell substrate of a busbar back contact cell according to an embodiment of the present disclosure;
Fig. 3 is a schematic diagram showing a partial structure of a busbar-free back contact cell according to an embodiment of the present disclosure;
Fig. 4 is a schematic diagram showing a partial structure of a busbar-free back contact cell according to an embodiment of the present disclosure;
Fig. 5 is a schematic diagram showing the structure of a partial region of a busbar-free back contact cell according to an embodiment of the present disclosure;

Explanation of main component symbols:
busbar-free back contact cell 100, cell substrate 10, electrically connected region 101, non-electrically connected region 102, first finger 111, first electrically connected region 1120, second finger 121, second electrically connected region 1220, current-confluence region 13, non-current-confluence region 14, first insulating member 21, second insulating member 22, conductive member 30.

### Detailed Description of the Embodiments

To make the objectives, technical solutions, and advantages of the present disclosure clearer and more comprehensible, the following provides a more detailed description of the present disclosure with reference to the accompanying drawings and embodiments. Examples of the embodiments are shown in the accompanying drawings, in which the same or similar reference numerals represent the same, similar elements or functionally equivalent elements. The embodiments described below with reference to drawings are merely exemplary, and are intended for explaining the present disclosure. The embodiments shall not be construed as limiting the present disclosure. In addition, it should be understood that the specific embodiments described herein are provided merely for explaining the present disclosure, but are not intended to limit the present disclosure.

In the description of the present disclosure, it should be understood that the orientations or position relationships indicated by the terms "length," "width," "up," "down," "left," "right," "horizontal," "top," "bottom," and the like are based on the orientations or position relationships shown in the accompanying drawings. They are provided solely for the convenience of describing the present disclosure and simplifying the description, and are not intended to indicate or imply that the indicated device or element must have a particular orientation, or be constructed and operated in a particular orientation. Therefore, they should not be construed as limiting the present disclosure.

In addition, terms such as "first" and "second" are used herein for descriptive purposes only and are not intended to indicate or imply relative importance, significance or the number of indicated technical features. Thus, the features defined by "first" and "second" can explicitly or implicitly include one or more of said features. In the description of the present disclosure, "a plurality of" means two or more than two, unless specified otherwise.

In the description of the present disclosure, it should be noted that, unless specified or limited otherwise, the terms "mounted," "connected," and "coupled" should be understood broadly. For example, they can refer to fixed connections, detachable connections, or integral connections; they can be mechanical connections, and can also be electrical connections or communication connections; they can be direct connections, can also be indirect connections via an intermediate medium; and they can be internal communication between two elements or an interaction relationship between two elements. The specific meanings of the above terms in the present disclosure can be understood by those skilled in the art according to specific situations.

**In** the present disclosure, unless specified or limited otherwise, a structure in which a first feature is "on" or "under" a second feature can include an embodiment in which the first feature is in direct contact with the second feature, and can also include an embodiment in which the first feature and the second feature are not in direct contact with each other, but are contacted via another feature formed therebetween. Furthermore, a first feature "on," "above," or "on top of" a second feature can include an embodiment in which the first feature is right or obliquely "on," "above," or "on top of" the second feature, or just means that the first feature is at a height higher than that of the second feature. While a first feature "below," "under," or "on bottom of" a second feature can include an embodiment in which the first feature is directly or obliquely "below," "under," or "on bottom of" the second feature, or just means that the first feature is at a height lower than that of the second feature.

The following disclosure provides many different embodiments or examples for implementing different structures of the present disclosure. To simplify the disclosure of the present disclosure, the components and arrangements of specific examples are described below. Of course, they are merely examples and are not intended to limit the present disclosure. In addition, reference numerals and/or letters can be repeated in various examples in the present disclosure for the purpose of simplicity and clarity, which do not in itself indicate relationships between various embodiments and/or arrangements discussed. In addition, examples of various specific processes and materials are provided in the present disclosure, but a person of ordinary skill in the art can recognize applications of other processes and/or usage scenarios of other materials.

In the present disclosure, as the first insulating members are arranged in the current-confluence regions and cover fingers having a polarity opposite to a polarity of the current-confluence regions, the conduction between the fingers of opposite polarity and ribbons can be avoided in the current-confluence regions, thereby reducing the risk of short circuits in the busbar-free back contact cell. In addition, as the conductive members are provided in the electrically connected region, they facilitate the connection between the fingers of the same polarity and the interconnectors, so that the interconnectors connect the busbar-free back contact cells in series into a cell string, and output current from the busbar-free back contact cells. Furthermore, as there is no busbar, the use of busbar paste can be omitted, reducing the cost.

### Embodiment 1

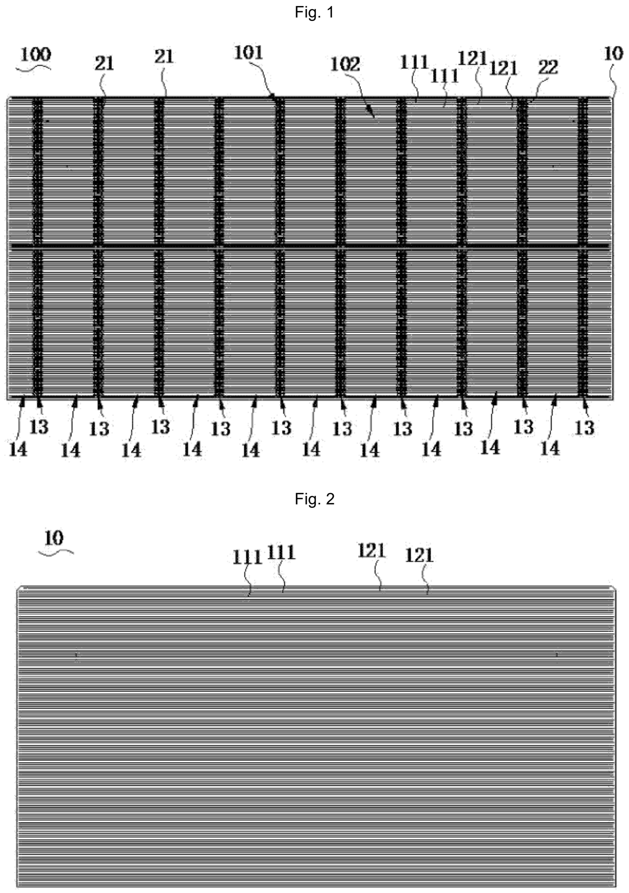

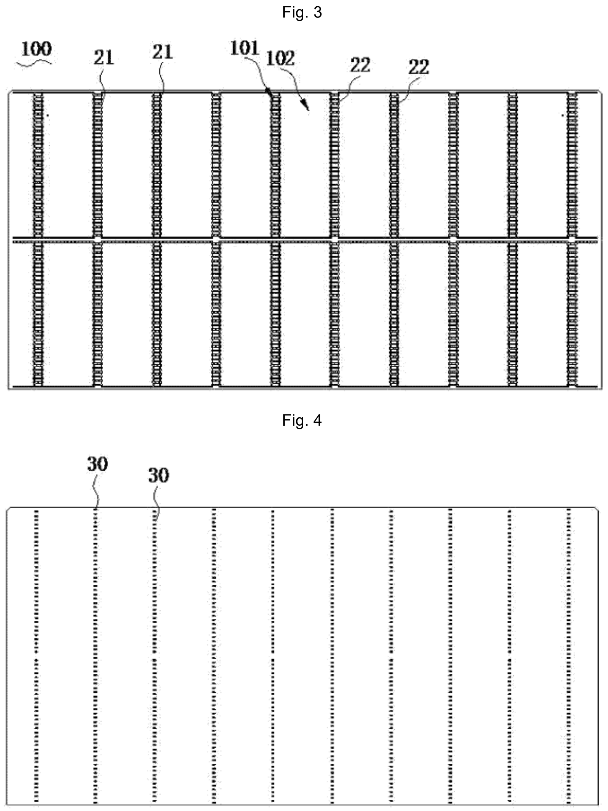

Please refer to Figs. 1, 2, 3, 4 and 5, a busbar-free back contact cell 100 according to the embodiments of the present disclosure, including a cell substrate 10, first insulating members 21 and conductive members, wherein alternately distributed fingers of two polarities are formed on the back surface of the cell substrate 10, the back surface includes alternately distributed current-confluence regions 13 and non-current-confluence regions 14, and parts of each finger are located in the current-confluence regions 13, and the rest parts of each finger is located in the non-current-confluence regions 14; the current-confluence regions 13 include electrically connected regions 101, and the first insulating members 21 are arranged in the current-confluence regions 13 and cover fingers having a polarity opposite to a polarity of the current-confluence regions 13 to expose the electrically connected regions 101; and the conductive members are arranged in the electrically connected regions 101.

According to the busbar-free back contact cell 100 in the embodiments of the present disclosure, as the first insulating members 21 are arranged in the current-confluence regions 13 and cover fingers having a polarity opposite to that of the current-confluence regions 13, the conduction between the fingers of opposite polarity and ribbons can be avoided in the current-confluence regions 13, thereby reducing the risk of short circuits in the busbar-free back contact cell 100. In addition, as the conductive members are arranged in the electrically connected region, they facilitate the connection between the fingers of the same polarity and the interconnectors, so that the interconnectors connect the busbar-free back contact cells 100 in series into a cell string, and output current from the busbar-free back contact cells 100. Furthermore, as there is no busbar, the use of busbar paste can be omitted, reducing the cost.

Meanwhile, when multiple busbar-free back contact cells 100 are stacked, the first insulating members 21 can prevent fingers from scratching another busbar-free back contact cell 100 in the areas covered by the first insulating members 21. Furthermore, as the first insulating members 21 have a certain thickness, gaps can be formed between the areas which are not covered by the first insulating members 21 and another busbar-free back contact cell 100, thereby preventing fingers from scratching another busbar-free back contact cell 100 in the areas which are not covered by the first insulating members 21. In this way, when the busbar-free back contact cells 100 are stacked, damage to the busbar-free back contact cells 100 can be reduced, and the need for separator paper between two adjacent busbar-free back contact cells 100 can be omitted, thereby reducing the cost of transporting or storing the busbar-free back contact cells 100.

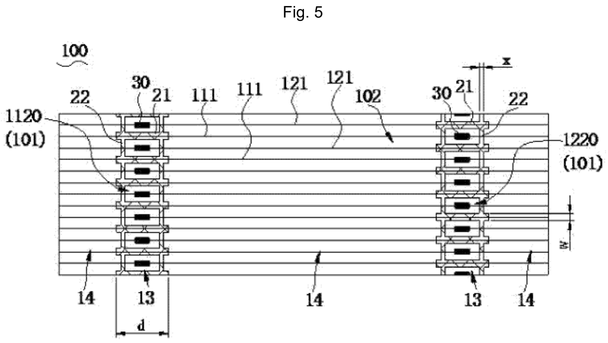

Optionally, in some embodiments, the busbar-free back contact cell 100 is a whole cell, in some embodiments, the busbar-free back contact cell 100 is a half cell, one-third cell, or other proportioned cell obtained by cutting a whole cell. To make the drawings clearer, the busbar-free back contact cell 100 shown in Figs. 1, 2, 3 and 4 is two cell segmentation areas of a whole five-segment busbar-free back contact cell 100. The morphology of the remaining regions of the five-segment busbar-free back contact solar cell 100, and the morphology of the busbar-free back contact solar cells 100 with other segment ratios, are similar to that shown in Figs. 1, 2, 3 and 4, and reference can be made to Figs. 1, 2, 3 and 4, which will not be repeated herein. Fig. 5 shows a partial region of the busbar-free back contact cell 100. Other regions of the busbar-free back contact cell 100 are similar to the morphology shown in Fig. 5, and reference can be made to Fig. 5, which will not be repeated herein. That is to say, the drawings are only examples, and do not represent limitations to the specific morphology of the busbar-free back contact cell 100.

Optionally, alternately distributed fingers of two polarities are formed on the back surface of the cell substrate 10, which are first fingers 111 and second fingers 121.

Optionally, the cell substrate 10 includes a front surface and a back surface opposite to each other; the front surface faces the sun and mainly receives direct sunlight, while the back surface faces a mounting surface of the cell module and mainly receives sunlight reflected by the mounting surface; and the mounting surface can be, for example, the ground, a roof, or the like. In other words, the back surface refers to the surface of the busbar-free back contact solar cell 100 on which grid lines are arranged.

Optionally, the alternating distribution means that one second finger 121 is arranged between every two adjacent first fingers 111, and one first finger 111 is arranged between every two adjacent second fingers 121. Optionally, one of the first fingers 111 and the second fingers 121 is positive electrode fingers, and the other of the first fingers 111 and the second fingers 121 is negative electrode fingers.

Optionally, the back surface includes current-confluence regions 13 and non-current-confluence regions 14 which are alternately distributed. In other words, a non-current-confluence region 14 is formed between two adjacent current-confluence regions 13, and a current-confluence region 13 is formed between two adjacent non-current-confluence regions 14.

Optionally, the arrangement direction of the alternating distribution of the current-confluence regions 13 and the non-current-confluence regions 14 is perpendicular to the arrangement direction of the alternating distribution of the first fingers 111 and the second fingers 121. It can be understood that, in other embodiments, the arrangement direction of the alternating distribution of the current-confluence regions 13 and the non-current-confluence regions 14 can also be angled with respect to the arrangement direction of the alternating distribution of the first fingers 111 and the second fingers 121, which is not limited herein.

Optionally, the current-confluence regions 13 have two polarities, which are respectively first current-confluence regions and second current-confluence regions, and the first current-confluence regions and the second current-confluence regions are alternately distributed. In other words, a second current-confluence region is formed between two adjacent first current-confluence regions, and a first current-confluence region is formed between two adjacent second current-confluence regions. Optionally, one of the first current-confluence regions and the second current-confluence regions is positive electrode current-confluence regions, and the other of the first current-confluence regions and the second current-confluence regions is negative electrode current-confluence regions.

It should be noted that the current-confluence regions 13 of the two polarities are alternatively distributed in the length direction of the fingers, one or more rows of cell segmentation areas can be formed in the width direction of the fingers, and each row of cell segmentation areas includes current-confluence regions 13 and non-current-confluence regions 14 which are alternatively distributed in the length direction of the fingers. The busbar-free back contact cell 100 can include insulating strips, and insulating strips cover the fingers located at the boundary between every two adjacent cell regions. In this way, cell segmentation technology can be used to reduce the current of individual cells, thereby reducing power loss after the same cells are packaged into a photovoltaic module, and improving module efficiency. It can be understood that, after segmentation, the current of each individual cell is reduced, which can reduce thermal loss, and the resistance is increased, which can reduce transmission loss. In this embodiment, the busbar-free back contact cell is a five-segment cell. It should be understood that, in other embodiments, the busbar-free back contact cell can also be a two-segment cell, a three-segment cell, a four-segment cell, or a six-segment cell, which is not limited herein.

Optionally, the busbar-free back contact cell is a three-segment cell and a four-segment cell. In this way, the increase in cutting loss is lower, the reduction in single-cell power loss is higher, the process complexity is lower, the overall effect is the best, and the power is optimal.

Optionally, the arrangement direction of the alternating distribution of the first current-confluence regions and the second current-confluence regions is perpendicular to the arrangement direction of the alternating distribution of the first fingers 111 and the second fingers 121. It can be understood that, the arrangement direction of the first current-confluence regions and the second current-confluence regions can also be angled with respect to the arrangement direction of the alternating distribution of the first fingers 111 and the second fingers 121, which is not limited herein.

Optionally, the first current-confluence regions and the second current-confluence regions are configured to arrange first interconnectors and second interconnectors, respectively. That is, the fingers of the same polarity are connected by the interconnectors of the same polarity.

Optionally, each current-confluence region 13 includes electrically connected regions 101. The interconnectors are electrically connected to the busbar-free back contact cell 100 in the electrically connected regions 101, and are connected in series with other busbar-free back contact cells 100 to form a cell string.

Optionally, the electrically connected regions 101 include first electrically connected regions 1120 and second electrically connected regions 1220 which have opposite polarities. The polarity of the first electrically connected regions 1120 is the same as the polarity of the first fingers 111, and the polarity of the second electrically connected regions 1220 is the same as the polarity of the second fingers 121.

Optionally, the electrically connected regions 101 expose fingers of two polarities, the first insulating members 21 are arranged in the current-confluence regions 13 and cover the fingers having a polarity opposite to the polarity of the current-confluence regions 13. In this way, the conduction between the fingers of opposite polarity and ribbons can be avoided in the current-confluence regions 13, thereby reducing the risk of short circuits in the busbar-free back contact cell 100.

Optionally, the non-electrically connected regions 102 are located in regions of the cell substrate 10 other than the electrically connected regions 101. In other words, the non-electrically connected regions 102 include regions of the current-confluence regions 13 other than the electrically connected regions 101 and the non-current-confluence regions 14.

In some optional embodiments, the electrically connected region 101 includes at least one of a solder pad region, a conductive adhesive region, and an conductive paste region. In other words, the electrically connected region 101 includes one or more of a solder pad region, a conductive adhesive region, and an conductive paste region.

In this way, the busbar-free back contact cell 100 and each interconnector can be connected by at least one of soldering pads, conductive adhesive, or conductive paste.

Optionally, the solder pad region can be provided with a conductive material. The conductive material is, for example, solder paste.

Optionally, the conductive adhesive region can be provided with conductive adhesive.

Optionally, the interconnector can be, for example, a ribbon, a conductive wire, a conductive adhesive tape, a conductive sheet, a conductive plate, or the like. Herein, description is made by taking an example that the interconnector is a ribbon, but this does not represent a limitation to the interconnector.

Optionally, the interconnectors have two polarities, each collecting current from fingers of the same polarity.

Please refer to Figs. 1, 2, 3 and 4, the first insulating members 21 are arranged in the current-confluence regions 13 and cover the fingers having a polarity opposite to the polarity of the current-confluence regions 13, and expose the electrically connected regions 101; and the conductive members are arranged in the electrically connected regions 101.

Optionally, the first insulating members 21 in the first current-confluence regions cover the second fingers 121 and expose the electrically connected regions 101 of the first current-confluence regions; and the first insulating members 21 in the second current-confluence regions cover the first fingers 111 and expose the electrically connected regions 101 of the second current-confluence regions.

Optionally, the first insulating members 21 in the current-confluence regions 13 fully cover the fingers having a polarity opposite to the polarity of the current-confluence regions 13. In other words, the portions of the fingers, having a polarity opposite to the polarity of the current-confluence regions 13, in the current-confluence regions 13 are entirely covered by the first insulating members 21. In this way, the fingers of opposite polarities and interconnectors are insulated from each other as much as possible.

Optionally, one end or two ends of the first insulating members 21 can also extend from current-confluence regions 13 to the non-current-confluence regions 14 along the length direction of the corresponding fingers. In this way, in the case of misalignment of the interconnectors, the risk of conduction with fingers of opposite polarity can be reduced.

Optionally, the conductive members partially cover the electrically connected regions 101. Optionally, the "partially cover" means that each conductive member covers a portion of, but not all of, a electrically connected region 101. In this way, the coverage area is smaller, which is beneficial for reducing the cost.

It should be understood that, in other embodiments, the conductive members can also fully cover the electrically connected regions 101. Optionally, "fully cover" means that each conductive member covers an entire electrically connected region 101. In this way, the process for arranging the conductive members is simpler, which is beneficial for improving the production efficiency.

Optionally, the center of each conductive member overlaps with the center of a electrically connected region 101. In this way, each conductive member is located at the central position of a electrically connected region 101, so that the connection between each interconnector and the busbar-free back contact cell 100 is more stable.

Optionally, the conductive members can be composed of conductive adhesive, and are fixed to the electrically connected regions 101 after curing. The conductive members can also be arranged on the electrically connected regions 101 by adhesive bonding. The conductive members can also be formed by solidification of solder after soldering. The specific method by which the conductive members are arranged on the electrically connected regions 101 is not limited herein.

Optionally, the electrically connected regions 101 are rectangular. It should be understood that, in other embodiments, the electrically connected regions 101 can also be circular, square, triangular or in other shapes. The specific shape of the electrically connected regions 101 is not limited herein.

Optionally, the contact surface of each conductive member with a electrically connected region 101 is rectangular. It should be understood that, in other embodiments, the contact surface of each conductive member with a electrically connected region 101 can also be circular, square, triangular or in other shapes. The specific shape of the contact surface of each conductive member with a electrically connected region 101 is not limited herein.

Optionally, the morphology of the electrically connected regions 101 can be the same as or different from the morphology of the contact surface of each conductive member with a electrically connected region 101.

### Embodiment 2

In some optional embodiments, the thickness of the first insulating members 21 is 10 µm-50 µm. For example, the thickness can be 10µm, 12µm, 15µm, 17µm, 20µm, 25µm, 28µm, 30µm, 35µm, 40µm, 42µm, 45µm, 49µm, or 50µm.

In this way, the thickness of the first insulating members 21 is in an appropriate range, which can avoid poor insulating effect caused by an excessively small thickness, and can also avoid material waste and increase costs caused by an excessively large thickness.

Optionally, the thickness of the first insulating members 21 is 20 µm-30 µm. In this way, the overall effect of insulation and cost-saving is optimal.

Please note that the thickness of the first insulating members 21 can be a certain constant value within 10 µm-50 µm, and can also fluctuate within 10 µm-50 µm.

### Embodiment 3

Please refer to Fig. 5, in some optional embodiments, the length d of the first insulating members 21 is 1 mm-3 mm. For example, the length can be 1 mm, 1.1 mm, 1.5 mm, 1.8 mm, 2 mm, 2.2 mm, 2.5 mm, 2.9 mm, or 3 mm.

In this way, the length of the first insulating members 21 is within an appropriate range, which can avoid a poor insulating effect caused by insufficient coverage of fingers of opposite polarity in the current-confluence regions 13 due to an excessively small length, and can also avoid material waste and increased costs due to an excessively large length.

Optionally, the length d of the first insulating members 21 is 1.5 mm-2.5 mm. In this way, the overall effect of insulation and cost-saving is optimal.

Please note that the length of the first insulating members 21 can be a certain constant value within 1.5 mm-2.5 mm, and can fluctuate within 1.5 mm-2.5 mm.

### Embodiment 4

In some optional embodiments, the width w of the insulating members 21 is 0.2 mm-0.6 mm. For example, the width can be 0.2 mm, 0.3 mm, 0.4 mm, 0.5 mm, or 0.6 mm.

In this way, the width w of the first insulating members 21 is within an appropriate range, which can avoid a poor insulating effect caused by insufficient coverage of fingers due to an excessively small width, and can also avoid material waste and increased costs due to an excessively large width.

Optionally, the width w of the first insulating members 21 is 0.4 mm. In this way, the overall effect of insulation and cost-saving is optimal.

Please note that the width w of the first insulating members 21 can be a certain constant value within 0.2 mm-0.6 mm and can also fluctuate within 0.2 mm-0.6 mm.

### Embodiment 5

In some optional embodiments, the height of the conductive members is 30 µm-100 µm. For example, the height can be 30 µm, 32 µm, 35 µm, 40 µm, 60 µm, 70 µm, 90 µm, 95 µm, or 100 µm.

In this way, the height of the conductive members is within an appropriate range, which can avoid difficulties in connecting to the interconnectors due to an excessively small height, and can also avoid material waste and increased costs due to an excessively large height.

Optionally, the height of the conductive members is 60 µm-70 µm. In this way, the overall effect is optimal.

Please note that the height of the conductive member can be a certain constant value within 30 µm to 100 µm, and can also fluctuate within 30 µm to 100 µm.

### Embodiment 6

Please refer to Fig. 5, in some optional embodiments, the area of the electrically connected regions 101 is 0.02 mm²-0.6 mm². For example, the area can be 0.02 mm², 0.03 mm², 0.375 mm², 0.4 mm², 0.5 mm², or 0.6 mm².

In this way, the area of the electrically connected regions 101 is in an appropriate range, which can avoid unstable connection between the busbar-free back contact cell 100 and the interconnectors due to an excessively small area, and can also avoid conductive material waste and poor insulating effect due to an excessively large area.

Optionally, the area of the electrically connected regions 101 is 0.375 mm², and they are rectangular, with a width of 0.15 mm and a length of 0.25 mm. In this way, the connection between the busbar-free back contact cell 100 and the interconnectors, the saving of conductive material and the insulating effect are all taken into account, and the overall effect is optimal.

### Embodiment 7

Please refer to Fig. 5, in some optional embodiments, the number of the electrically connected regions 101 is 1000-4000. For example, the number can be 1000, 1500, 2000, 2500, 3000, 3500, 3800, or 4000.

In this way, the number of the electrically connected regions 101 is within an appropriate range, which can avoid unstable connection between the busbar-free back contact cell 100 and the interconnectors due to an excessively small number, and can also avoid reduced efficiency and increased costs due to an excessively large number.

It should be noted that the 1000-4000 number range corresponds to a single, complete busbar-free back contact cell 100. It can be understood that, in the case where the busbar-free back contact cell 100 is divided into half, one-third, or other proportion of the full cell, the number of the electrically connected regions 101 can be determined on the basis of the division ratio and the range of 1000-4000. For example, in the case where the busbar-free back contact cell 100 is a half-cell obtained by dividing a full cell, the number of the electrically connected regions 101 is 500-2000.

### Embodiment 8

Please refer to Fig. 5, in some optional embodiments, the busbar-free back contact cell 100 includes second insulating members 22, and each second insulating member 22 connects two adjacent first insulating members 21, and together with the adjacent first insulating members, encloses the electrically connected region.

In this way, the first insulating members 21 and the second insulating member 22 which are connected enclose the electrically connected region 101, which can block the conductive material from flowing from the electrically connected region 101 to the fingers of opposite polarity on the interconnectors, thereby avoiding conduction between the interconnectors and the fingers of opposite polarity, ensuring the normal operation of the busbar-free back contact cell 100, and reducing the risk of short circuits in the busbar-free back contact cell 100. Meanwhile, this can also block the conductive material from flowing from the electrically connected region 101 to the fingers of the same polarity on the interconnectors, so that the height of the conductive members formed by curing the conductive material is relatively low, thereby avoiding poor connection with the interconnectors.

Optionally, two first insulating members 21 and two second insulating members 22 can enclose a rectangular electrically connected region 101, the two first insulating members 21 are respectively located on two opposite sides of the rectangle, and the two second insulating members 22 are respectively located on the other two opposite sides of the rectangle.

It should be understood that, in other embodiments, the number of the second insulating members 22 corresponding to each electrically connected region 101 can be 3, 4, 5, or another number, the first insulating members 21 and the second insulating members 22 can enclose the electrically connected regions 101 in other shapes, and the specific enclosing arrangement of the first insulating members 21 and the second insulating members 22 are not limited herein.

### Embodiment 9

Please refer to Fig. 5, in some optional embodiments, the width x of the second insulating members 22 is 1 mm-3 mm. For example, the width can be 1 mm, 1.2 mm, 1.5 mm, 2 mm, 2.3 mm, 2.5 mm, 2.7 mm, or 3 mm.

In this way, the width x of the second insulating members 22 is within an appropriate range, which can avoid the failure in blocking the conductive material from flowing out due to an excessively small width, and can also avoid material waste and increased costs due to an excessively large width.

Optionally, the width x of the second insulating members 22 is 2 mm. In this way, the overall effect of insulation and cost-saving is optimal.

Please note that the width x of the second insulating members 22 can be a certain constant value within 1 mm-3 mm, and can also fluctuate within 1 mm-3 mm.

### Embodiment 10

In some optional embodiments, the first insulating members 21 are transparent insulating members.

In this way, the shading of sunlight by the first insulating members 21 can be reduced, so that more sunlight is absorbed by the busbar-free back contact solar cell 100, which is beneficial to improving the photoelectric conversion efficiency.

Please note that transparent means that the first insulating members 21 have a visible light transmittance of greater than or equal to 70% at a thickness of 20 micrometres.

It should be understood that, in other embodiments, the first insulating members 21 can be non-transparent insulating members. No limitation is made herein.

In some optional embodiments, the second insulating members 22 are transparent insulating members. In this way, the shading of sunlight by the insulating members can be further reduced, which is beneficial for further improving the photoelectric conversion efficiency.

Please note that the explanation and description regarding the second insulating members 22 being transparent insulating members are similar to those for the first insulating members 21; and reference can be made to the relevant content of the first insulating members 21, and details are not repeated herein.

### Embodiment 11

In some optional embodiments, the first insulating members 21 are transparent fluorescent insulating members.

In this way, the first insulating members 21 emit light when irradiated by a light source of a corresponding wavelength, thereby facilitating the detection of the positions of the first insulating members 21, and improving the accuracy of arranging the first insulating members 21 in the busbar-free back contact solar cell 100.

In some optional embodiments, the second insulating members 22 are transparent fluorescent insulating members. In this way, the second insulating members 22 emit light when irradiated by a light source of a corresponding wavelength, thereby facilitating the detection of the positions of the second insulating members 22, and improving the accuracy of arranging the second insulating members 22 in the back contact solar cell.

Please note that the explanation and description regarding the second insulating members 22 being transparent fluorescent insulating members are similar to those for the first insulating members 21; and reference can be made to the relevant content of the first insulating members 21, and details are not repeated herein.

### Embodiment 12

In some optional embodiments, the transparent fluorescent insulating members are composed of a transparent insulating adhesive. The transparent insulating adhesive includes: a resin component in an amount of 60 to 80 wt%; an inorganic filler in an amount of 5 to 15 wt%; a curing agent in an amount of 5 to 15 wt%; a solvent in an amount of less than 10 wt%; and a phosphor in an amount of greater than or equal to 0.1 wt% and less than 1 wt%.

In this way, as the insulating adhesive is a transparent insulating material, the shading of sunlight can be reduced, so that more sunlight is absorbed by the busbar-free back contact cell 100, which is beneficial to improving the photoelectric conversion efficiency. Meanwhile, as the transparent insulating adhesive includes a phosphor in a mass percentage of greater than or equal to 0.1% and less than 1%, the transparent insulating adhesive emits light under the irradiation of a light source with a corresponding wavelength, thereby facilitating the detection of the position of the transparent insulating adhesive, and improving the accuracy of arranging the transparent insulating adhesive on the busbar-free back contact cell 100.

Optionally, the transparent insulating adhesive can be applied to the busbar-free back contact cell 100 by screen printing, jet dispensing, coating, or the like.

Optionally, the coverage area proportion of the transparent insulating adhesive on the busbar-free back contact cell 100 is greater than 10%.

Optionally, the mass percentage of the resin component is, for example, 60%, 62%, 65%, 70%, 73%, 75%, 78%, or 80%. In this way, the mass percentage of the resin component is within an appropriate range, which can reduce the brittleness of the first insulating members 21 formed by curing the insulating adhesive, and improve the bending resistance and impact resistance of the first insulating members 21.

Optionally, the mass percentage of the inorganic filler is, for example, 5%, 6%, 8%, 10%, 11%, 14%, or 15%. In this way, relatively inexpensive inorganic filler can be used to reduce the amount of resin component, thereby reducing the cost of the transparent insulating adhesive. Furthermore, the inorganic filler can enhance the mechanical properties of the transparent insulating adhesive, making the insulating adhesive easier to apply and adhere.

Optionally, the mass percentage of the curing agent is, for example, 5%, 8%, 10%, 11%, 14%, or 15%. In this way, the transparent insulating adhesive can be cured within a predetermined process time.

Optionally, the mass percentage of the solvent is, for example, 9.99%, 9%, 7%, 5%, 4%, 2%, or 0.1%. In this way, the solvent can dissolve other materials in the transparent insulating adhesive and adjust the viscosity of the transparent insulation adhesive.

Optionally, the mass percentage of the phosphor is, for example, 0.99%, 0.95%, 0.8%, 0.6%, 0.5%, 0.3%, or 0.1%. The phosphor can cause whitening, and when its mass percentage is greater than or equal to 1%, it can affect the transmittance of the transparent insulating adhesive itself. In addition, when the mass percentage of the phosphor is greater than or equal to 0.1% and less than 1%, the insulating adhesive can exhibit relatively good light transmittance, which is beneficial for ensuring the photoelectric conversion efficiency. Furthermore, when the mass percentage of the phosphor is greater than or equal to 0.1% and less than 1%, it does not lead to excessively high costs, which is beneficial for ensuring that the insulating adhesive can be detected while also maintaining the normal operation of the solar cell and reducing the cost of the busbar-free back contact cell 100.

**In some optional embodiments, the resin component includes at least one of modified polyacrylate, modified polyurethane, modified polyamide, modified polyesteramide, modified** polycarbonate, modified silicone grease, modified styrene ester, polystyrene, polytetrafluoroethylene, polyoxymethylene, modified phenolic ester, modified polyester, modified polyimide ester, and modified epoxy resin. In this way, providing various forms of resin component enables adaptation to a wider range of practical production scenarios and practical production requirements, which is beneficial for improving the production efficiency of the transparent insulation adhesive. Moreover, the resin component can reduce the brittleness of the first insulating members 21 formed by curing the transparent insulating adhesive, and improve the bending resistance and impact resistance of the first insulating members 21.

In some optional embodiments, the inorganic filler includes talc powder. In this way, by using the relatively inexpensive talc powder, the amount of resin component can be reduced,, thereby lowering the cost of the transparent insulating adhesive. Furthermore, the talc powder can enhance the thermal stability and corrosion resistance of the transparent insulation adhesive, improving the overall quality of the transparent insulation adhesive. In addition, the talc powder has insulating properties, which can improve the insulating performance of the transparent insulating adhesive.

In some optional embodiments, the talc powder includes at least one of barium sulfate, calcium carbonate, and titanium dioxide. In this way, providing various forms of talc powder enables adaptation to a wider range of practical production scenarios and practical production requirements, which is beneficial for improving the production efficiency of the transparent insulation adhesive.

In some optional embodiments, the curing agent includes an imidazole derivative. In this way, by using the imidazole derivative as the curing agent, the curing speed of the insulating adhesive can be increased, and the curing cost can be reduced.

In some optional embodiments, the imidazole derivative includes at least one of aliphatic amine, aromatic compound, and anhydride curing agent. In this way, providing various forms of curing agent enables adaptation to a wider range of practical production scenarios and practical production requirements, which is beneficial for improving the production efficiency of the transparent insulation adhesive. Optionally, the aliphatic amine includes ethylenediamine and/or phenylenediamine. For example, the aliphatic amine includes ethylenediamine; as another example, the aliphatic amine includes xylylenediamine; as a further example, the aliphatic amine includes both ethylenediamine and xylylenediamine. Optionally, the aromatic compound includes meta-phenylenediamine and/or diaminodiphenylmethane. For example, the aromatic compound includes m-phenylenediamine; as another example, the aromatic compound includes diaminodiphenylmethane; as a further example, the aromatic compound includes both m-phenylenediamine and diaminodiphenylmethane. Optionally, the anhydride curing agent includes phthalic anhydride and/or hexahydrophthalic anhydride. For example, the anhydride curing agent includes phthalic anhydride; for another example, the anhydride curing agent includes hexahydrophthalic anhydride; and as a further example, the anhydride curing agent includes both phthalic anhydride and hexahydrophthalic anhydride.

In some optional embodiments, the solvent includes at least one of dimethyl adipate, dimethyl succinate, dimethyl glutarate, dimethyl malonate, diethyl adipate, diethyl succinate, diethyl glutarate, dibutyl succinate, dibutyl glutarate, DBE, DBE-3, DBE-4, DBE-6, DBE-9, DBE-IB, and DBE-ME. In this way, the dicarboxylate esters can better serve as the solvent, can react with the resin component to form chain or cyclic polymers, and form stable solid compounds after volatilization. Furthermore, providing various forms of dicarboxylate ester can enables adaptation to a wider range of practical production scenarios and practical production requirements, which is beneficial for improving the production efficiency of the transparent insulation adhesive.

### Embodiment 13

In some optical embodiments, the phosphor includes at least one of fluorescent brightener OB-1, fluorescent brightener OB, aluminum oxide, zinc oxide, zinc sulfide, calcium sulfide, strontium sulfide, strontium aluminate, calcium chlorate, barium aluminate, rare-earth phosphors, fluorescent brightener BC, fluorescent brightener JD-3, fluorescent brightener BR, fluorescent brightener EBF, fluorescent brightener R, fluorescent brightener ER, 1,8-naphthalimide-based fluorescent compounds, polyphenylene, polythiophene, polyfluorene, polytriphenylamine, triphenylamine-based polymer derivatives, polycarbazole, polypyrrole, porphyrin-based polymers and derivatives thereof, copolymers, N,N-dimethylaminobenzylidene malononitrile compounds, 8-hydroxyquinoline aluminum, and europium metal complexs.

In this way, providing various forms of phosphors can enables adaptation to a wider range of practical production scenarios and practical production requirements, which is beneficial for improving the production efficiency of the transparent insulation adhesive.

Optionally, the rare-earth fluorescent material refers to a fluorescent material containing rare-earth elements. That is, a fluorescent material containing at least one rare-earth element selected from europium, samarium, erbium, and neodymium.

In some embodiments, the phosphor is a fluorescent brightener OB-1. When the insulating adhesive with the fluorescent brightener OB-1 as the phosphor is irradiated with ultraviolet light, the visible fluorescent color is blue, providing a strong visual effect.

In the table below, the resin component, the curing agent and the solvent of the transparent insulating adhesive are respectively: 70% phenolic epoxy resin, 10% imidazole derivative and 5% anisole. The phosphor is fluorescent brightener OB-1, and the inorganic filler is barium sulfate. The mass percentages of OB-1 and barium sulfate are shown in the following table.

The table below shows the fluorescence gray value, viscosity value and light transmittance of the transparent insulation adhesive at a thickness of 20 micrometers, corresponding to different addition amounts of the fluorescent brightener OB-1. It is understood that the fluorescence grayscale value can represent the fluorescence effect. The viscosity value can represent printability, with the best printability achieved when the viscosity value is between 150 dPa·s and 250 dPa·s. Apparently, when the mass percentage of the phosphor is greater than or equal to 1%, although the fluorescence effect of the transparent insulating adhesive is strong, both the printability and the light transmittance are poor. When the mass percentage of the phosphor is greater than or equal to 0.1 % and less than 1%, the fluorescence of the transparent insulating adhesive is sufficient to be detected, and both the printability and the light transmittance are relatively good. Therefore, when the mass percentage of the phosphor is greater than or equal to 0.1% and less than 1%, it can ensure the detectability, the fluorescent effect and the printability, thus improving the overall performance of the transparent insulating adhesive.

**[Table 1_sm_0001]**

| .Mass percentage of fluorescent brightener OB-1 | Mass percentage of barium sulfate | Fluorescence gray value | Viscosity value (dpa•s) | Light transmittance |
|---|---|---|---|---|
| 0.10% | 14.9% | 200 | 150 | 85-90% |
| 0.30% | 14.7% | 240 | 180 | 85-90% |
| 0.60% | 14.4% | 260 | 200 | 85-90% |
| 0.90% | 14.1% | 270 | 250 | 85-90% |
| 1% | 14% | 280 | 300 | 80-85% |
| 2% | 2% | 290 | 350 | 80-85% |
| 5% | 5% | 310 | 380 | 70-80% |

In some embodiments, the phosphor is alumina. When the insulating adhesive with alumina as the phosphor is irradiated with ultraviolet light, the visible fluorescence color is light blue, providing a strong visual effect.

In the table below, the resin component, the curing agent and the solvent of the transparent insulating adhesive are respectively: 70% phenolic epoxy resin, 10% imidazole derivative and 5% anisole. The phosphor is aluminum oxide, and the inorganic filler is barium sulfate. The mass percentages of alumina and barium sulfate are shown in the table below.

The table below shows the fluorescence gray value, the viscosity value and the light transmittance of the transparent insulation adhesive at a thickness of 20 micrometers, corresponding to different addition amounts of the alumina. Apparently, when the mass percentage of the phosphor is greater than or equal to 1%, although the fluorescence effect of the transparent insulating adhesive is strong, both the printability and the light transmittance are poor. When the mass percentage of the phosphor is greater than or equal to 0.1% and less than 1%, the fluorescence of the transparent insulating adhesive is sufficient to be detected, and both the printability and the light transmittance are relatively good. Therefore, when the mass percentage of the phosphor is greater than or equal to 0.1% and less than 1%, it can ensure the detectability, the fluorescent effect and the printability, thus improving the overall performance of the transparent insulating adhesive.

**[Table 1_sm_0002]**

| Phosphor | Mass percentage | Fluorescence gray value | Viscosity value (dpa•s) | Light transmittance |
|---|---|---|---|---|
| aluminum oxide | 0.10% | 100 | 150 | 85-90% |
| aluminum oxide | 0.5% | 150 | 180 | 85-90% |
| aluminum oxide | 1% | 180 | 300 | 80-85% |
| aluminum oxide | 5% | 200 | 380 | 70-80% |

Please note that specific data for the phosphor being the fluorescent brightener OB-1 and specific data for the phosphor being alumina are provided here. For other phosphors, such as fluorescent brightener OB, zinc oxide, zinc sulfide, calcium sulfide, strontium sulfide, strontium aluminate, calcium chlorate, barium aluminate, rare-earth phosphors, fluorescent brightener BC, fluorescent brightener JD-3, fluorescent brightener BR, fluorescent brightener EBF, fluorescent brightener R, fluorescent brightener ER, 1,8-naphthalimide-based fluorescent compounds, polyphenylene, polythiophene, polyfluorene, polytriphenylamine, triphenylamine-based polymer derivatives, polycarbazole, polypyrrole, porphyrin-based polymers and derivatives thereof, copolymers, N,N-dimethylaminobenzylidene malononitrile compounds, 8-hydroxyquinoline aluminum, and europium metal complexs, when the mass percentage is greater than or equal to 0.1% and less than 1%, the range of the fluorescence gray value that represents the fluorescent effect is 100-300, the range of the viscosity value that represents the printability is 150-300, and the range of the transmittance is 85%-90%. To avoid redundancy, no further description will be given here.

In other embodiments, the phosphor can include fluorescent brightener OB; in other embodiments, the phosphor can include barium aluminate, rare-earth phosphors, fluorescent brightener BC, and fluorescent brightener JD-3; in other embodiments, the phosphor can include fluorescent brightener EBF, fluorescent brightener R, fluorescent brightener ER, and 1,8-naphthalimide-based fluorescent compounds. The specific form of the phosphor is not limited herein.

Optionally, at least one type of light selected from green light, blue light, infrared light, ultraviolet light, and white light can be used to irradiate the busbar-free back contact cell 100, so that the first insulating members 21 formed by curing the transparent insulating adhesive emit fluorescence, thereby accurately detecting the position of the transparent insulating adhesive.

### Embodiment 14

The cell module in the embodiments of the present disclosure includes the busbar-free back contact cell 100 in any one of the embodiments 1 to 13.

In this way, in the busbar-free back contact cell 100, as the first insulating members 21 are arranged in the current-confluence regions 13 and cover fingers having a polarity opposite to that of the current-confluence regions 13, the conduction between the fingers of opposite polarity and ribbons can be avoided in the current-confluence regions 13, thereby reducing the risk of short circuits in the busbar-free back contact cell 100. In addition, as the conductive members are arranged in the electrically connected region, they facilitate the connection between the fingers of the same polarity and the interconnectors, so that the interconnectors connect the busbar-free back contact cells 100 in series into a cell string, and output current from the busbar-free back contact cells 100. Furthermore, as there is no busbar, the use of busbar paste can be omitted, reducing the cost.

In this embodiment, a plurality of busbar-free back contact cells 100 in the cell module can be connected together in series sequentially, so as to form a cell string, thereby achieving series current collection and output. For example, the series connection of the cells can be implemented by using ribbons (busbars or interconnect ribbons), a conductive backsheet, or other means.

It can be understood that, in such an embodiment, the cell module can further include a metal frame, a backsheet, photovoltaic glass, and encapsulant film. The encapsulant film can be filled between the front and back surfaces of the busbar-free back contact cell 100 and the photovoltaic glass and between adjacent cells, serving as a filler. The encapsulant film can be a transparent colloid with good light transmittance and aging resistance. For example, the encapsulant film can be an EVA encapsulant film or a POE encapsulant film, which can be selected according to actual situations, and is not limited herein.

The photovoltaic glass can cover the encapsulant film on the front surface of the busbar-free back contact cell 100. The photovoltaic glass can be ultra-clear glass, which possesses high light transmittance, transparency, and superior physical, mechanical, and optical properties. For example, the light transmittance of the ultra-clear glass can be up to 92% or more, so that the photovoltaic glass can protect the busbar-free back contact cell 100 without affecting the efficiency of the busbar-free back contact cell 100 as far as possible. Meanwhile, the encapsulant film can bond the photovoltaic glass and the busbar-free back contact cell 100 together, and the presence of the encapsulant film can provide sealing, insulation, and protection against water and moisture for the busbar-free back contact cell 100.

The backsheet can be attached to the encapsulant film on the back surface of the busbar-free back contact cell 100. The backsheet can provide protection and support for the busbar-free back contact cell 100, having reliable insulation, water resistance and aging resistance. The backsheet can have multiple options, typically including tempered glass, organic glass, aluminum alloy, TPT composite encapsulant film, etc., which can be selected according to specific situations, and is not limited herein. The overall structure consisting of the backsheet, the busbar-free back contact cell 100, the encapsulant film and the photovoltaic glass can be arranged on a metal frame. The metal frame serves as the main external support structure for the entire cell module, providing stable support and mounting for the cell module. For example, the cell module can be mounted at a position required to be mounted via the metal frame.

### Embodiment 15

The photovoltaic system of the embodiments of the present disclosure includes the cell module of embodiment 14.

In this way, in the busbar-free back contact cell 100, as the first insulating members 21 are arranged in the current-confluence regions 13 and cover fingers having a polarity opposite to that of the current-confluence regions 13, the conduction between the fingers of opposite polarity and ribbons can be avoided in the current-confluence regions 13, thereby reducing the risk of short circuits in the busbar-free back contact cell 100. In addition, as the conductive members are arranged in the electrically connected region, they facilitate the connection between the fingers of the same polarity and the interconnectors, so that the interconnectors connect the busbar-free back contact cells 100 in series into a cell string, and output current from the busbar-free back contact cells 100. Furthermore, as there is no busbar, the use of busbar paste can be omitted, reducing the cost.

In this embodiment, the photovoltaic system can be applied to photovoltaic power stations, such as ground-mounted power stations, rooftop power stations, and floating power stations, and can also be applied to devices or apparatuses that utilize solar energy for power generation, such as residential solar power supplies, solar streetlights, solar vehicles, and solar buildings. Certainly, it can be understood that, the application scenarios of the photovoltaic system are not limited thereto, that is, the photovoltaic system can be applied in all fields that require to utilize solar energy for power generation. Taking a photovoltaic power generation system network as an example, a photovoltaic system can include a photovoltaic array, a combiner box and an inverter. The photovoltaic array can be an array combination of a plurality of cell modules. For example, a plurality of cell modules can constitute a plurality of photovoltaic arrays. The photovoltaic arrays are connected to the combiner box. The combiner box can collect the current generated by the photovoltaic arrays. After the current is combined, it flows through the inverter, where it is converted into alternating current meeting the electric grid requirements, and then connected to the electric grid to achieve solar power supply.

Reference throughout this description to "some embodiments," "illustrative embodiments," "an example," "a specific example," or "some examples," means that a particular feature, structure, material, or characteristic described in connection with the embodiment or example is included in at least one embodiment or example of the present disclosure. Thus, the appearances of the phrases in various places throughout this description are not necessarily referring to the same embodiment or example of the present disclosure. Furthermore, the particular features, structures, materials, or characteristics can be combined in any suitable manner in one or more embodiments or examples.

In addition, the foregoing is only preferred embodiments of the present disclosure, and is not intended to limit the present disclosure. Any modification, equivalent replacement, and improvement made within the spirit and principle of the present disclosure shall fall within the scope of protection of the present disclosure.

## Claims

1. A busbar-free back contact cell, comprising a cell substrate, first insulating members and conductive members, wherein alternately distributed fingers of two polarities are formed on a back surface of the cell substrate, the back surface comprises alternately distributed current-confluence regions and non-current-confluence regions, and parts of each finger are located in the current-confluence regions, and rest parts of each finger are located in the non-current-confluence regions; the current-confluence regions comprise electrically connected regions, and the first insulating members are arranged in the current-confluence regions and cover fingers having a polarity opposite to a polarity of the current-confluence regions to expose the electrically connected regions; and the conductive members are arranged in the electrically connected regions.

2. The busbar-free back contact cell according to claim 1, wherein a thickness of the first insulating members is 10 µm-50 µm.

3. The busbar-free back contact cell according to claim 1, wherein a length of the first insulating members is 1 mm-3 mm.

4. The busbar-free back contact cell according to claim 1, wherein a width of the first insulating members is 0.2 mm-0.6 mm.

5. The busbar-free back contact cell according to claim 1, wherein a height of the conductive members is 30 µm-100 µm.

6. The busbar-free back contact cell according to claim 1, wherein an area of the electrically connected regions is 0.02 mm²-0.6 mm².

7. The busbar-free back contact cell according to claim 1, wherein a number of the electrically connected regions is 1000-4000.

8. The busbar-free back contact cell according to claim 1, wherein the busbar-free back contact cell comprises second insulating members, and each second insulating member connects two adjacent first insulating members and, together with the adjacent first insulating members, encloses the electrically connected region.

9. The busbar-free back contact cell according to claim 8, wherein a width of the second insulating members is 1 mm-3 mm.

10. The busbar-free back contact cell according to claim 1, wherein the first insulating members are transparent insulating members.

11. The busbar-free back contact cell according to claim 10, wherein the first insulating members are transparent fluorescent insulating members.

12. The back contact cell according to claim 11, wherein the transparent fluorescent insulating members are composed of a transparent insulating adhesive, and the transparent insulating adhesive comprises:
a resin component in an amount of 60 to 80 wt%;
an inorganic filler in an amount of 5 to 15 wt%;
a curing agent in an amount of 5 to 15 wt%;
a solvent in an amount of less than 10 wt%; and
a phosphor in an amount of greater than or equal to 0.1 wt% and less than 1 wt%.

13. The back contact cell according to claim 12, wherein the phosphor comprises at least one of fluorescent brightener OB-1, fluorescent brightener OB, aluminum oxide, zinc oxide, zinc sulfide, calcium sulfide, strontium sulfide, strontium aluminate, calcium chlorate, barium aluminate, rare-earth phosphors, fluorescent brightener BC, fluorescent brightener JD-3, fluorescent brightener BR, fluorescent brightener EBF, fluorescent brightener R, fluorescent brightener ER, 1,8-naphthalimide-based fluorescent compounds, polyphenylene, polythiophene, polyfluorene, polytriphenylamine, triphenylamine-based polymer derivatives, polycarbazole, polypyrrole, porphyrin-based polymers and derivatives thereof, copolymers, N,N-dimethylaminobenzylidene malononitrile compounds, 8-hydroxyquinoline aluminum, and europium metal complexs.

14. A cell module, comprising the busbar-free back contact cell according to any one of claims 1 to 13.

15. A photovoltaic system, comprising the cell module according to claim 14.
